# EUROPEAN PATENT APPLICATION

(11) **EP 4 741 851 A1**
(43) Date of publication of application: **13.05.2026**
(21) Application number: 24854328.2
(22) Date of filing: 22.07.2024
(51) Int. Cl.: G01R 31/385, G01R 31/396, G01R 19/12, G01R 19/00, G01R 19/165, G01R 19/30

(54) **BATTERY DIAGNOSIS DEVICE AND OPERATION METHOD THEREOF**

(30) Priority: 11.08.2023 KR 20230105935
(71) Applicant: LG Energy Solution, Ltd., Seoul 07335 (KR)
(72) Inventor: PARK, Jae Dong, Daejeon 34122 (KR); YOON, Ho Byung, Daejeon 34122 (KR); LEE, Jeong Hwan, Daejeon 34122 (KR)
(74) Representative: Plasseraud IP
(86) International application number: PCT/KR2024/010545
(87) International publication number: WO 2025/037776

(57) **Abstract**

A battery diagnosis apparatus according to an embodiment disclosed herein includes a pulse application unit configured to apply a plurality of pulses to a battery and a controller configured to obtain a first voltage corresponding to at least any one pulse among the plurality of pulses, calculate a voltage change rate based on the first voltage and a time during which the first voltage is obtained, and diagnose abnormality of the battery based on the voltage change rate.

## Description

### [TECHNICAL FIELD]

### CROSS-REFERENCE TO RELATED APPLICATION

This application claims priority to and the benefit of Korean Patent Application No. 10-2023-0105935 filed in the Korean Intellectual Property Office on August 11, 2023, the entire content of which is incorporated herein by reference.

### TECHNICAL FIELD

Embodiments disclosed herein relate to a battery diagnosis apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

The battery measures and determines the state thereof through a battery management system (BMS) mounted thereon so as to be used normally. Thus, there are various diagnosis methods for cases where various information measured through BMS falls beyond a normal range or shows abnormality. However, a behavior of the battery may be changed variously for a state of charge (SOC) and a state of health (SOH), making it difficult to accurately derive abnormal diagnosis.

### [DISCLOSURE]

### [TECHNICAL PROBLEM]

Embodiments disclosed herein aim to provide a battery diagnosis apparatus and an operating method thereof in which a battery may be precisely diagnosed.

Embodiments disclosed herein aim to provide a battery diagnosis apparatus and an operating method thereof in which a battery may be diagnosed based on a response to a pulse applied to the battery.

Technical problems of the embodiments disclosed herein are not limited to the above-described technical problems, and other unmentioned technical problems would be clearly understood by one of ordinary skill in the art from the following description.

### [TECHNICAL SOLUTION]

A battery diagnosis apparatus according to an embodiment disclosed herein includes a pulse application unit configured to apply a plurality of pulses to a battery and a controller configured to obtain a first voltage corresponding to at least any one pulse among the plurality of pulses, calculate a voltage change rate based on the first voltage and a time during which the first voltage is obtained, and diagnose abnormality of the battery based on the voltage change rate.

In an embodiment, the pulse application unit may be further configured to apply at least any one of a charging pulse and a discharging pulse to the battery.

In an embodiment, the pulse application unit may be further configured to alternately apply the charging pulse, a rest period, and the discharging pulse to the battery.

In an embodiment, the pulse application unit may be further configured to obtain, as the first voltage, a voltage corresponding to a discharging pulse among the plurality of pluses.

In an embodiment, the controller may be further configured to calculate, as an average voltage, an average of the first voltage corresponding to the at least any one pulse and
diagnose abnormality of the battery based on a change rate of the average voltage.

In an embodiment, the controller may be further configured to calculate, as an average voltage, an average of the first voltage corresponding to each of the plurality of pulses and diagnose abnormality of the battery based on a change rate of the average voltage.

In an embodiment, the controller may be further configured to convert a time axis of the first voltage into a logscale and calculate, as the voltage change rate, a change rate of the first voltage with respect to the time axis converted into the logscale.

In an embodiment, the controller may be further configured to calculate the voltage change rate by calculating a differential value (dV/d(log(t)) of the first voltage with respect to a logscale time.

In an embodiment, the controller may be further configured to diagnose abnormality of a battery based on at least one of a change rate of the differential value of the first voltage with respect to the logscale time, a peak value of the differential value of the first voltage with respect to the logscale time, a maximum value of the differential value of the first voltage with respect to the logscale time, a minimum value of the differential value of the first voltage with respect to the logscale time, and a normal distribution of the differential value of the first voltage with respect to the logscale time.

In an embodiment, the controller may be further configured to obtain the first voltage based on a voltage after a set time from application of the discharging pulse among the plurality of pulses.

In an embodiment, the controller may be further configured to fit the first voltage into an equation and calculate the voltage change rate based on the equation.

In an embodiment, the controller may be further configured to diagnose abnormality of each of the plurality of battery cells included in the battery when each of the plurality of battery cells has a same degree of degradation.

In an embodiment, the controller may be further configured to extract the first voltage by correcting temperature imbalance of the battery.

An operating method of a battery diagnosis apparatus according to an embodiment disclosed herein includes applying a plurality of pulses to a battery, obtaining a first voltage corresponding to at least any one pulse among the plurality of pulses, calculating a voltage change rate based on the first voltage and a time during which the first voltage is obtained, and diagnosing abnormality of the battery based on the voltage change rate.

In an embodiment, the applying of the plurality of pulses to the battery may include alternately applying a charging pulse, a rest period, and a discharging pulse to the battery.

In an embodiment, the obtaining of the first voltage corresponding to the at least any one pulse among the plurality of pulses may include calculating, as an average voltage, an average of the first voltage corresponding to the at least any one pulse.

In an embodiment, the obtaining of the first voltage corresponding to the at least any one pulse among the plurality of pulses may include calculating, as an average voltage, an average of the first voltage corresponding to each of the plurality of pulses.

In an embodiment, the calculating of the voltage change rate based on the first voltage and the time during which the first voltage is obtained may include converting a time axis of the first voltage into a logscale and calculating, as the voltage change rate, a change rate of the first voltage with respect to the time axis converted into the logscale.

In an embodiment, the calculating, as the voltage change rate, of the change rate of the first voltage with respect to the time axis converted into the logscale may include calculating a differential value (dV/d(log(t)) of the first voltage with respect to a logscale time.

In an embodiment, the diagnosing of abnormality of the battery based on the voltage change rate may include diagnosing abnormality of a battery based on at least one of a change rate of the differential value of the first voltage with respect to the logscale time, a peak value of the differential value of the first voltage with respect to the logscale time, a maximum value of the differential value of the first voltage with respect to the logscale time, a minimum value of the differential value of the first voltage with respect to the logscale time, and a normal distribution of the differential value of the first voltage with respect to the logscale time.

### [ADVANTAGEOUS EFFECTS]

A battery diagnosis apparatus and an operating method thereof according to an embodiment disclosed herein may precisely diagnose a battery.

The battery diagnosis apparatus and the operating method thereof according to an embodiment disclosed herein may create a standardized situation for a battery and analyze a difference in the corresponding situation to accurately diagnose the battery.

The battery diagnosis apparatus and the operating method thereof according to an embodiment disclosed herein may apply a pulse to a battery and diagnose the battery based on a variance of a voltage response to a pulse.

In addition, various effects identified directly or indirectly through this document may be provided.

### [DESCRIPTION OF DRAWINGS]

FIG. 1 is a block diagram of a battery diagnosis apparatus according to an embodiment disclosed herein.
FIG. 2 shows an example in which a battery diagnosis apparatus applies a pulse, according to an embodiment disclosed herein.
FIG. 3 shows an example in which a battery diagnosis apparatus obtains a response to a pulse, according to an embodiment disclosed herein.
FIG. 4 is a view showing an operating method of a battery diagnosis apparatus according to an embodiment disclosed herein.
FIG. 5 is a flowchart showing in detail an operating method of a battery diagnosis apparatus according to an embodiment disclosed herein.
FIG. 6 is a block diagram showing a hardware configuration of a computing system for performing an operating method of a battery diagnosis apparatus, according to an embodiment disclosed herein.

### [MODE FOR INVENTION]

Hereinafter, embodiments disclosed herein will be described in detail through exemplary drawings. In adding reference numerals to components of each drawing, it should be noted that the same components have the same numerals as much as possible even though they are displayed on different drawings. Moreover, in describing the embodiments disclosed herein, when it is determined that a detailed description of a related known configuration or function interferes with understanding of the embodiment disclosed herein, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. The terms defined in a generally used dictionary should be interpreted as having the same meanings as the contextual meanings of the relevant technology and should not be interpreted as having ideal or exaggerated meanings unless they are clearly defined in the present application.

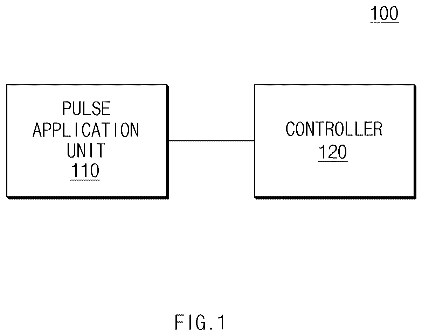

FIG. 1 shows a battery diagnosis apparatus according to an embodiment disclosed herein.

Referring to FIG. 1, the battery diagnosis apparatus 100 according to an embodiment disclosed herein may include a pulse application unit 110 and a controller 120.

According to an embodiment, the battery diagnosis apparatus 100 may be included in a battery management system (BMS) of a battery, or a server, a cloud server, etc. According to another embodiment, the battery diagnosis apparatus 100 may be included in an apparatus for a charging/discharging test such as a charging/discharging cycler or may be included in various devices for diagnosing or testing the battery.

The pulse application unit 110 may apply a plurality of pulses to the battery. For example, the pulse application unit 110 may apply at least any one of a charging pulse and a discharging pulse to the battery. In another example, the pulse application unit 110 may alternately apply the charging pulse and the discharging pulse to the battery.

According to an embodiment, the pulse application unit 110 may alternately apply the charging pulse and the discharging pulse to the battery and may not set a rest period between the charging pulse and the discharging pulse. According to another embodiment, the pulse application unit 110 may alternately apply the charging pulse and the discharging pulse to the battery and may set the rest period therebetween.

According to an embodiment, the pulse application unit 110 may continuously apply the charging pulse to the battery. For example, the pulse application unit 110 may apply the charging pulse to the battery, set the rest period, and apply the charging pulse again, thereby continuously applying the charging pulse during a set period.

According to an embodiment, the pulse application unit 110 may continuously apply the discharging pulse to the battery. For example, the pulse application unit 110 may apply the discharging pulse to the battery, set the rest period, and apply the discharging pulse again, thereby continuously applying the discharging pulse during a set period.

According to an embodiment, the pulse application unit 110 may alternately apply, to the battery, the charging pulse, the rest period, and the discharging pulse that are set according to specific conditions. For example, the pulse application unit 110 apply a pulse to the battery in such a way to apply a charging pulse of 0.1 second, to have a rest period of 0.1 second, to apply a discharging pulse of 0.1 second, and to repeat the foregoing process. However, the present disclosure is not limited thereto, and the pulse application unit 110 may apply a pulse to the battery by determining an application time of the charging pulse, whether to apply the charging pulse, whether to have the rest period, a rest period time, an application time of the discharging pulse, and whether to apply the discharging pulse.

According to an embodiment, the pulse application unit 110 may alternatively apply the charging pulse and the discharging pulse a plurality of times. For example, the pulse application unit 110 may alternatively apply the charging pulse and the discharging pulse three to ten times. However, the present disclosure is not limited thereto, and the pulse application unit 110 may alternately apply the charging pulse and the discharging pulse n times (n is a natural number).

According to an embodiment, the pulse application unit 110 may apply the charging pulse and the discharging pulse as current.

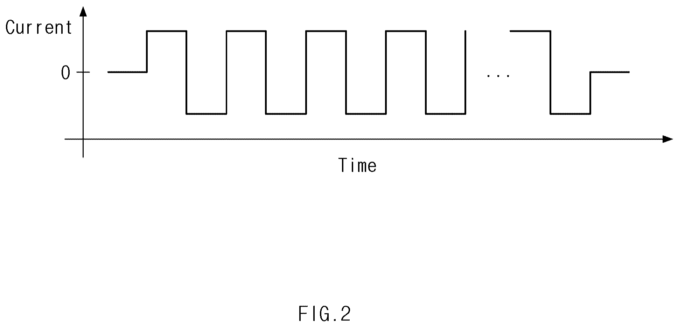

FIG. 2 shows an example in which a battery diagnosis apparatus applies a pulse, according to an embodiment disclosed herein.

Referring to FIG. 2, the pulse application unit 110 of the battery diagnosis apparatus 100 may apply a pulse to the battery. While the pulse application unit 110 alternately applies the charging pulse and the discharging pulse in FIG. 2, the present disclosure is not limited thereto.

According to an embodiment, the pulse application unit 110 may apply various pulses to the battery through repetition of the charging pulse and the discharging pulse, repetition of the charging pulse and the rest period, repetition of the discharging pulse and the rest period, repetition of the charging pulse, the rest period, and the discharging pulse, etc.

Referring back to FIG. 1, the controller 120 may obtain a first voltage corresponding to at least one of a plurality of pulses. For example, the controller 120 may obtain a voltage corresponding to a discharging pulse of the plurality of pulses as the first voltage. In another example, the controller 120 may obtain the first voltage corresponding to one or all of the plurality of pulses. In another example, the controller 120 may obtain a voltage response corresponding to each of the plurality of pulses and obtain all or some of the obtained voltage responses as the first voltages.

According to an embodiment, the controller 120 may calculate, as an average voltage, an average of the first voltage corresponding to at least one pulse. For example, the controller 120 may extract at least any one pulse from among the plurality of pulses according to a criterion and calculate an average voltage as an average of the first voltage corresponding to the extracted at least one pulse. In another embodiment, the controller 120 may calculate, as an average voltage, an average of the first voltages corresponding to all or some pulses for each of the plurality of pulses. According to an embodiment, the controller 120 may calculate an average voltage by calculating an average of the first voltages corresponding to pulses having low noises among the plurality of pulses. In this case, the controller 120 may diagnose abnormality of the battery based on a change rate of the average voltage.

According to an embodiment, the controller 120 may calculate, as the average voltage, the average of the first voltage corresponding to each of the plurality of pulses. In this case, the controller 120 may diagnose abnormality of the battery based on a change rate of the average voltage.

According to an embodiment, when the charging pulse and the discharging pulse are repeated 5 times, the controller 120 may obtain, as 5 first voltages corresponding to 5 discharging pulses, voltage responses corresponding to the discharging pulse repeated 5 times or calculate, as an average voltage, an average of all or some of the 5 first voltages. That is, the controller 120 may obtain the first voltage(s) corresponding to one pulse or a plurality of pulses and diagnose the battery based on the obtained first voltage(s).

The controller 120 may calculate a voltage change rate based on the first voltage and a time during which the first voltage is obtained. For example, the controller 120 may calculate a change rate per time of the first voltage. In another example, the controller 120 may calculate d(first voltage)/dt.

The controller 120 may diagnose abnormality of the battery based on a voltage change rate. For example, the controller 120 may diagnose abnormality of the battery based on a change rate, a peak value, a maximum value, a minimum value, a normal distribution, etc., of the voltage change rate. According to an embodiment, the controller 120 may analyze the voltage change rate of the battery and a voltage change rate of another battery comparatively with each other to diagnose abnormality of the battery.

According to an embodiment, the controller 120 may diagnose, as an abnormal battery, a battery having a higher gradient of the voltage change rate than that of the other battery or than a normal battery. In another example, the controller 120 may diagnose, as an abnormal battery, a battery having a higher gradient of the voltage change rate than a threshold value.

According to an embodiment, the controller 120 may diagnose, as an abnormal battery, a battery having a higher peak value of the voltage change rate than that of the other battery or than a normal battery. In another example, the controller 120 may diagnose, as an abnormal battery, a battery having a higher peak value of the voltage change rate than a threshold value.

According to an embodiment, the controller 120 may diagnose, as an abnormal battery, a battery having a higher minimum value or maximum value of the voltage change rate than that of the other battery or than a normal battery. In another example, the controller 120 may diagnose, as an abnormal battery, a battery having a higher minimum value or maximum value of the voltage change rate than a threshold value.

According to an embodiment, the controller 120 may calculate a normal distribution of the voltage change rate, and diagnose, as an abnormal battery, a battery having a difference than the other battery or than a normal battery. In another example, the controller 120 may calculate the normal distribution of the voltage change rate and diagnose, as an abnormal battery, a battery having a difference of at least a threshold value than that of the normal battery.

According to an embodiment, the controller 120 may convert a time axis of a first voltage to a log scale and calculate, as the voltage change rate, the change rate of the first voltage with respect to the time axis converted to the log scale. For example, the controller 120 may calculate the voltage change rate by calculating a differential value of the first voltage with respect to the logscale (logarithm) time by using d(first voltage)/d(log(t)).

According to an embodiment, the controller 120 may diagnose abnormality of a battery based on at least one of a change rate of the differential value of the first voltage with respect to the logscale time, a peak value of the first voltage with respect to the logscale time, a maximum value of the first voltage with respect to the logscale time, a minimum value of the first voltage with respect to the logscale time, and a normal distribution of the first voltage with respect to the logscale time. For example, the controller 120 may analyze a diagnosis factor of the first voltage with respect to the logscale time comparatively with a diagnosis factor of the other battery to diagnose whether the battery is abnormal.

According to an embodiment, the controller 120 may diagnose, as an abnormal battery, a battery having a higher change rate of a differential value of the first voltage with respect to the logscale time than the other battery or than a normal battery. In another example, the controller 120 may diagnose, as an abnormal battery, a battery having a higher change rate of a differential value of the first voltage with respect to the logscale time than a threshold value.

According to an embodiment, the controller 120 may diagnose, as an abnormal battery, a battery having a higher peak value of the differential value of the first voltage with respect to the logscale time than the other battery or than a normal battery. In another example, the controller 120 may diagnose, as an abnormal battery, a battery having a peak value of the differential value of the first voltage with respect to the logscale time than a threshold value.

According to an embodiment, the controller 120 may diagnose, as an abnormal battery, a battery having a higher minimum value or maximum value of the differential value of the first voltage with respect to the logscale time than the other battery or than a normal battery. In another example, the controller 120 may diagnose, as an abnormal battery, a battery having a minimum value or maximum value of the differential value of the first voltage with respect to the logscale time than a threshold value.

According to an embodiment, the controller 120 may calculate a normal distribution of the differential value of the first voltage with respect to the logscale time and diagnose, as an abnormal battery, a battery having difference than the other battery or than a normal battery. In another example, the controller 120 may calculate the normal distribution of the differential value of the first voltage with respect to the logscale time and diagnose, as an abnormal battery, a battery having a difference of at least a threshold value than that of the normal battery.

According to an embodiment, the controller 120 may easily identify a trend, improve the determinant power of the obtained numerical value, and process a component in an exponential format into a linear format, by processing the first voltage based on the logscale.

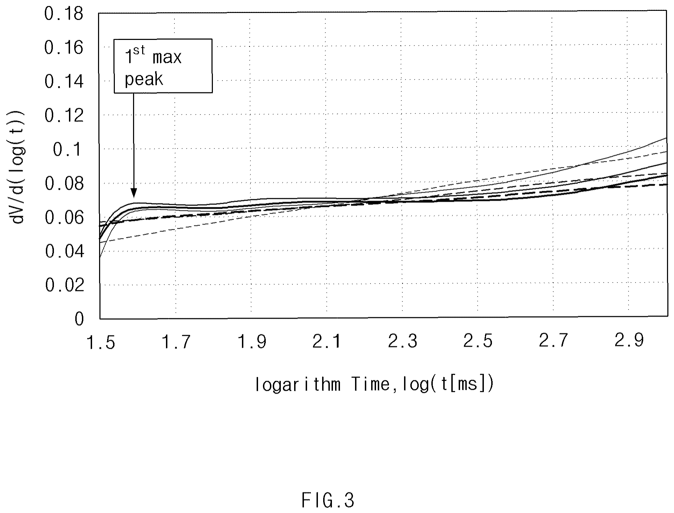

FIG. 3 shows an example in which a battery diagnosis apparatus obtains a response to a pulse, according to an embodiment disclosed herein.

Referring to FIG. 3, the controller 120 of the battery diagnosis apparatus 100 according to an embodiment disclosed herein may apply a pulse to a battery and calculate a voltage change rate of the first voltage obtained in response thereto.

While the differential value of the first voltage with respect to the logscale time is shown in FIG. 3, the present disclosure is not limited thereto and the controller 120 of the battery diagnosis apparatus 100 according to an embodiment disclosed herein may calculate the voltage change rate of the first voltage, process noise of the first voltage, calculate the voltage change rate, calculate an average of a plurality of first voltages, and calculate a change rate of an average voltage.

The controller 120 may diagnose abnormality of the battery based on the calculated voltage change rate. For example, the controller 120 may diagnose abnormality of the battery based on a peak value of the voltage change rate.

Referring back to FIG. 1, the controller 120 may obtain the first voltage based on a voltage after a set time from application of a discharging pulse among a plurality of pulses. For example, the set time may correspond to current stabilization. In another example, the controller 120 may obtain the first voltage based on a voltage after a rising time or a falling time.

According to an embodiment, the controller 120 may fit the first voltage to an equation and calculate the voltage change rate based on the equation. For example, the equation may include various expressions such as polynomial expressions, exponential expressions, etc.

According to an embodiment, the controller 120 may diagnose abnormality of each of a plurality of battery cells included in a battery when each of the plurality of battery cells has the same degree of degradation.

According to an embodiment, the controller 120 may obtain the first voltage by correcting the temperature imbalance of the battery. For example, when a charging pulse or a discharging pulse is applied to the battery, the temperature of the battery may rise and a different behavior may appear, such that the first voltage may be obtained by a behavior according to a temperature.

The battery diagnosis apparatus 100 according to an embodiment disclosed herein may precisely diagnose the battery.

The battery diagnosis apparatus 100 according to an embodiment disclosed herein may create a standardized situation for a battery and analyze a difference in the corresponding situation to accurately diagnose the battery.

The battery diagnosis apparatus 100 according to an embodiment disclosed herein may apply a pulse to a battery and diagnose the battery based on a variance of a voltage response to a pulse.

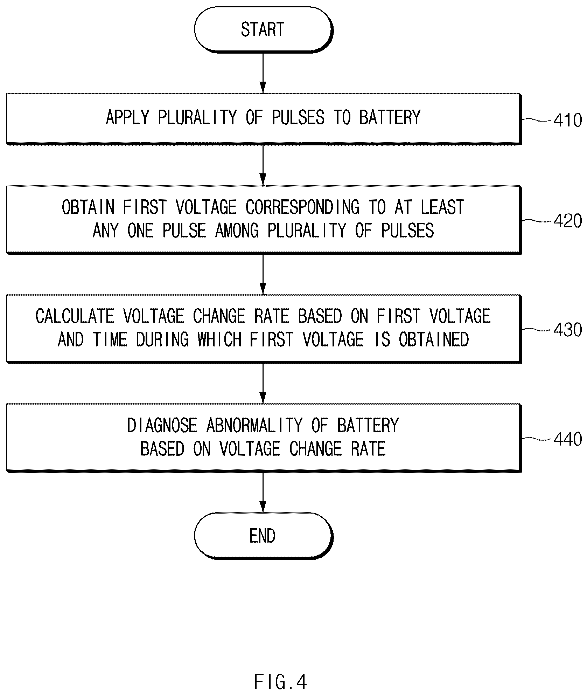

FIG. 4 is a view showing an operating method of a battery diagnosis apparatus according to an embodiment disclosed herein. According to an embodiment, operations shown in FIG. 4 may be performed by the battery diagnosis apparatus 100 of FIG. 1.

Referring to FIG. 4, in operation 410, the pulse application unit 110 may apply a plurality of pulses to the battery. For example, the pulse application unit 110 may apply at least any one of a charging pulse and a discharging pulse to the battery. In another example, the pulse application unit 110 may alternately apply the charging pulse and the discharging pulse to the battery.

According to an embodiment, the pulse application unit 110 may alternately apply the charging pulse and the discharging pulse to the battery and may not set a rest period between the charging pulse and the discharging pulse. According to another embodiment, the pulse application unit 110 may alternately apply the charging pulse and the discharging pulse to the battery and may set the rest period therebetween.

According to an embodiment, the pulse application unit 110 may continuously apply the charging pulse to the battery. For example, the pulse application unit 110 may apply the charging pulse to the battery, set the rest period, and apply the charging pulse again, thereby continuously applying the charging pulse during a set period.

According to an embodiment, the pulse application unit 110 may continuously apply the discharging pulse to the battery. For example, the pulse application unit 110 may apply the discharging pulse to the battery, set the rest period, and apply the discharging pulse again, thereby continuously applying the discharging pulse during a set period.

According to an embodiment, the pulse application unit 110 may alternatively apply the charging pulse and the discharging pulse a plurality of times. For example, the pulse application unit 110 may alternatively apply the charging pulse and the discharging pulse three to ten times. However, the present disclosure is not limited thereto, and the pulse application unit 110 may alternately apply the charging pulse and the discharging pulse n times (n is a natural number).

In operation 420, the controller 120 may obtain the first voltage corresponding to at least any one of the plurality of pulses. For example, the controller 120 may obtain a voltage corresponding to a discharging pulse of the plurality of pulses as the first voltage. In another example, the controller 120 may obtain the first voltage corresponding to one or all of the plurality of pulses. In another example, the controller 120 may obtain a voltage response corresponding to each of the plurality of pulses and obtain all or some of the obtained voltage responses as the first voltages.

According to an embodiment, the controller 120 may calculate, as an average voltage, an average of the first voltage corresponding to at least one pulse. For example, the controller 120 may extract at least any one pulse from among the plurality of pulses according to a criterion and calculate an average voltage as an average of the first voltage corresponding to the extracted at least one pulse. In another embodiment, the controller 120 may calculate, as an average voltage, an average of the first voltages corresponding to all or some pulses for each of the plurality of pulses. According to an embodiment, the controller 120 may calculate an average voltage by calculating an average of the first voltages corresponding to pulses having low noises among the plurality of pulses. In this case, the controller 120 may diagnose abnormality of the battery based on a change rate of the average voltage.

According to an embodiment, the controller 120 may calculate, as the average voltage, the average of the first voltage corresponding to each of the plurality of pulses. In this case, the controller 120 may diagnose abnormality of the battery based on a change rate of the average voltage.

In operation 430, the controller 120 may calculate a voltage change rate based on the first voltage and a time during which the first voltage is obtained. For example, the controller 120 may calculate a change rate per time of the first voltage. In another example, the controller 120 may calculate d(first voltage)/dt.

In operation 440, the controller 120 may diagnose abnormality of the battery based on a voltage change rate. For example, the controller 120 may diagnose abnormality of the battery based on a change rate, a peak value, a maximum value, a minimum value, a normal distribution, etc., of the voltage change rate. According to an embodiment, the controller 120 may analyze the voltage change rate of the battery and a voltage change rate of another battery comparatively with each other to diagnose abnormality of the battery.

According to an embodiment, the controller 120 may diagnose, as an abnormal battery, a battery having a higher gradient of the voltage change rate than that of the other battery or than a normal battery. In another example, the controller 120 may diagnose, as an abnormal battery, a battery having a higher gradient of the voltage change rate than a threshold value.

According to an embodiment, the controller 120 may diagnose, as an abnormal battery, a battery having a higher peak value of the voltage change rate than that of the other battery or than a normal battery. In another example, the controller 120 may diagnose, as an abnormal battery, a battery having a higher peak value of the voltage change rate than a threshold value.

According to an embodiment, the controller 120 may diagnose, as an abnormal battery, a battery having a higher minimum value or maximum value of the voltage change rate than that of the other battery or than a normal battery. In another example, the controller 120 may diagnose, as an abnormal battery, a battery having a higher minimum value or maximum value of the voltage change rate than a threshold value.

According to an embodiment, the controller 120 may calculate a normal distribution of the voltage change rate, and diagnose, as an abnormal battery, a battery having a difference than the other battery or than a normal battery. In another example, the controller 120 may calculate the normal distribution of the voltage change rate and diagnose, as an abnormal battery, a battery having a difference of at least a threshold value than that of the normal battery.

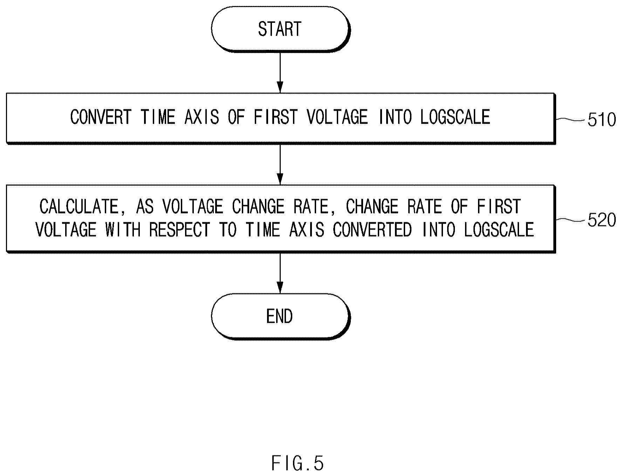

FIG. 5 is a flowchart showing in detail an operating method of a battery diagnosis apparatus according to an embodiment disclosed herein. According to an embodiment, operations shown in FIG. 5 may be performed by the battery diagnosis apparatus 100 of FIG. 1.

Referring to FIG. 5, in operation 510, the controller 120 may convert the time axis of the first voltage into a logscale.

In operation 520, the controller 120 may calculate a voltage change rate based on the voltage change rate of first voltage with respect to the time axis converted into the logscale. For example, the controller 120 may calculate the voltage change rate by calculating a differential value of the first voltage with respect to the logscale (logarithm) time by using d(first voltage)/d(log(t)).

According to an embodiment, operations 510 and 520 may be included in operation 430 of FIG. 4.

In this case, the controller 120 may diagnose abnormality of a battery based on at least one of a change rate of the differential value of the first voltage with respect to the logscale time, a peak value of the first voltage with respect to the logscale time, a maximum value of the first voltage with respect to the logarithmic scale time, a minimum value of the first voltage with respect to the logscale time, and a normal distribution of the first voltage with respect to the logscale time. For example, the controller 120 may analyze a diagnosis factor of the first voltage with respect to the logscale time comparatively with a diagnosis factor of the other battery to diagnose whether the battery is abnormal.

According to an embodiment, the controller 120 may diagnose, as an abnormal battery, a battery having a higher change rate of a differential value of the first voltage with respect to the logscale time than the other battery or than a normal battery. In another example, the controller 120 may diagnose, as an abnormal battery, a battery having a higher change rate of a differential value of the first voltage with respect to the logscale time than a threshold value.

According to an embodiment, the controller 120 may diagnose, as an abnormal battery, a battery having a higher peak value of the differential value of the first voltage with respect to the logscale time than the other battery or than a normal battery. In another example, the controller 120 may diagnose, as an abnormal battery, a battery having a peak value of the differential value of the first voltage with respect to the logscale time than a threshold value.

According to an embodiment, the controller 120 may diagnose, as an abnormal battery, a battery having a higher minimum value or maximum value of the differential value of the first voltage with respect to the logscale time than the other battery or than a normal battery. In another example, the controller 120 may diagnose, as an abnormal battery, a battery having a minimum value or maximum value of the differential value of the first voltage with respect to the logscale time than a threshold value.

According to an embodiment, the controller 120 may calculate a normal distribution of the differential value of the first voltage with respect to the logscale time and diagnose, as an abnormal battery, a battery having a higher difference than the other battery or than a normal battery. In another example, the controller 120 may calculate the normal distribution of the differential value of the first voltage with respect to the logscale time and diagnose, as an abnormal battery, a battery having a difference of at least a threshold value than that of the normal battery.

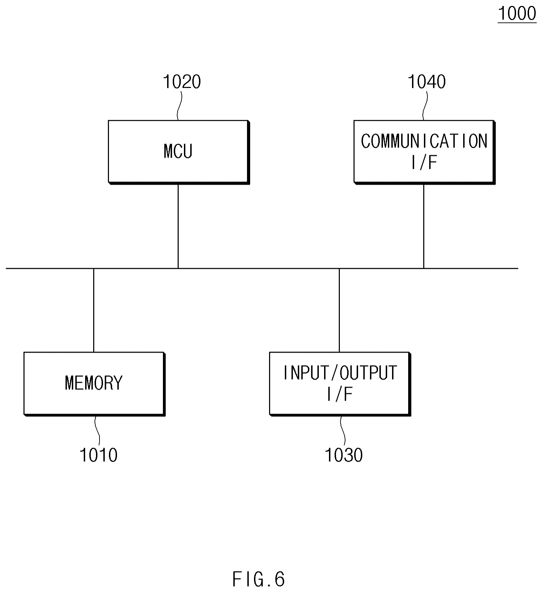

FIG. 6 is a block diagram showing a hardware configuration of a computing system for performing an operating method of a battery diagnosis apparatus, according to an embodiment disclosed herein.

Referring to FIG. 6, a computing system 1000 according to an embodiment disclosed herein may include a microcontroller unit (MCU) 1010, a memory 1020, an input/output interface (I/F) 1030, and a communication I/F 1040.

The MCU 1010 may be a processor that executes various programs (e.g., a pulse generation program, a voltage extraction program, a voltage change rate calculation program, etc.) stored in the memory 1020, processes various information including a voltage of a battery, a change rate of a battery voltage, abnormality of the battery, etc., through these programs, and executes the above-described functions of the controller included in the battery diagnosis apparatus shown in FIG. 1.

The memory 1020 may store various programs such as a pulse generation program, a voltage extraction program, a voltage change rate calculation program, etc. Moreover, the memory 1020 may store various information such as the voltage of the battery, the change rate of the battery voltage, abnormality of the battery, etc.

The memory 1020 may be provided in plural, depending on a need. The memory 1020 may be a volatile or nonvolatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., with the MCU 1010.

The communication I/F 1040, which is a component capable of transmitting and receiving various data to and from a server, may be various types of devices capable of supporting wired or wireless communication. For example, the battery diagnosis apparatus may transmit and receive various information including various information such as the voltage of the battery, the change rate of the battery voltage, abnormality of the battery, etc., from an external server separately provided through the communication I/F 1040.

As such, a computer program according to an embodiment disclosed herein may be recorded in the memory 1020 and processed by the MCU 1010, thus being implemented as a module that performs functions shown in FIG. 1.

The above description is merely illustrative of the technical idea disclosed herein, and various modifications and variations will be possible without departing from the essential characteristics of the embodiments disclosed herein by those of ordinary skill in the art to which the embodiments disclosed herein pertains.

Therefore, the embodiments disclosed herein are intended for description rather than limitation of the technical spirit of the embodiments disclosed herein and the scope of the technical spirit disclosed herein is not limited by these embodiments. The protection scope of the technical spirit disclosed herein should be interpreted by the following claims, and all technical spirits within the same range should be understood to be included in the range of this document.

## Claims

1. A battery diagnosis apparatus comprising:
a pulse application unit configured to apply a plurality of pulses to a battery; and
a controller configured to:
obtain a first voltage corresponding to at least any one pulse among the plurality of pulses;
calculate a voltage change rate based on the first voltage and a time during which the first voltage is obtained; and
diagnose abnormality of the battery based on the voltage change rate.

2. The battery diagnosis apparatus of claim 1, wherein the pulse application unit is further configured to apply at least any one of a charging pulse and a discharging pulse to the battery.

3. The battery diagnosis apparatus of claim 2, wherein the pulse application unit is further configured to alternately apply the charging pulse, a rest period, and the discharging pulse to the battery.

4. The battery diagnosis apparatus of claim 1, wherein the controller is further configured to obtain, as the first voltage, a voltage corresponding to a discharging pulse among the plurality of pulses.

5. The battery diagnosis apparatus of claim 1, wherein the controller is further configured to:
calculate, as an average voltage, an average of the first voltage corresponding to the at least any one pulse; and
diagnose abnormality of the battery based on a change rate of the average voltage.

6. The battery diagnosis apparatus of claim 1, wherein the controller is further configured to:
calculate, as an average voltage, an average of the first voltage corresponding to each of the plurality of pulses; and
diagnose abnormality of the battery based on a change rate of the average voltage.

7. The battery diagnosis apparatus of claim 1, wherein the controller is further configured to:
convert a time axis of the first voltage into a logscale; and
calculate, as the voltage change rate, a change rate of the first voltage with respect to the time axis converted into the logscale.

8. The battery diagnosis apparatus of claim 7, wherein the controller is further configured to calculate the voltage change rate by calculating a differential value (dV/d(log(t)) of the first voltage with respect to a logscale time.

9. The battery diagnosis apparatus of claim 8, wherein the controller is further configured to diagnose abnormality of a battery based on at least one of a change rate of the differential value of the first voltage with respect to the logscale time, a peak value of the differential value of the first voltage with respect to the logscale time, a maximum value of the differential value of the first voltage with respect to the logscale time, a minimum value of the differential value of the first voltage with respect to the logscale time, and a normal distribution of the differential value of the first voltage with respect to the logscale time.

10. The battery diagnosis apparatus of claim 1, wherein the controller is further configured to obtain the first voltage based on a voltage after a set time from application of the discharging pulse among the plurality of pulses.

11. The battery diagnosis apparatus of claim 1, wherein the controller is further configured to:
fit the first voltage into an equation; and
calculate the voltage change rate based on the equation.

12. The battery management apparatus of claim 1, wherein the controller is further configured to diagnose abnormality of each of the plurality of battery cells included in the battery when each of the plurality of battery cells has a same degree of degradation.

13. The battery diagnosis apparatus of claim 1, wherein the controller is further configured to extract the first voltage by correcting temperature imbalance of the battery.

14. An operating method of a battery diagnosis apparatus, the operating method comprising:
applying a plurality of pulses to a battery;
obtaining a first voltage corresponding to at least any one pulse among the plurality of pulses;
calculating a voltage change rate based on the first voltage and a time during which the first voltage is obtained; and
diagnosing abnormality of the battery based on the voltage change rate.

15. The operating method of claim 14, wherein the applying of the plurality of pulses to the battery comprises alternately applying a charging pulse and a discharging pulse to the battery.

16. The operating method of claim 14, wherein the obtaining of the first voltage corresponding to the at least any one pulse among the plurality of pulses comprises calculating, as an average voltage, an average of the first voltage corresponding to the at least any one pulse.

17. The operating method of claim 14, wherein the obtaining of the first voltage corresponding to the at least any one pulse among the plurality of pulses comprises calculating, as an average voltage, an average of the first voltage corresponding to each of the plurality of pulses.

18. The operating method of claim 14, wherein the calculating of the voltage change rate based on the first voltage and the time during which the first voltage is obtained comprises:
converting a time axis of the first voltage into a logscale; and
calculating, as the voltage change rate, a change rate of the first voltage with respect to the time axis converted into the logscale.

19. The operating method of claim 18, wherein the calculating, as the voltage change rate, of the change rate of the first voltage with respect to the time axis converted into the logscale comprises calculating a differential value (dV/d(log(t)) of the first voltage with respect to a logscale time.

20. The operating method of claim 19, wherein the diagnosing of abnormality of the battery based on the voltage change rate comprises diagnosing abnormality of a battery based on at least one of a change rate of the differential value of the first voltage with respect to the logscale time, a peak value of the differential value of the first voltage with respect to the logscale time, a maximum value of the differential value of the first voltage with respect to the logscale time, a minimum value of the differential value of the first voltage with respect to the logscale time, and a normal distribution of the differential value of the first voltage with respect to the logscale time.
